# EUROPEAN PATENT APPLICATION

(11) **EP 4 174 938 A1**
(43) Date of publication of application: **03.05.2023**
(21) Application number: 22199565.7
(22) Date of filing: 04.10.2022
(51) Int. Cl.: H01L 23/495

(54) **LEADFRAME PACKAGE WITH METAL INTERPOSER**

(30) Priority: 29.10.2021 US 202163273169 P; 19.09.2022 US 202217948195
(71) Applicant: MediaTek Inc., Hsin-Chu 300 (TW)
(72) Inventor: CHANG, Chu-Chia, 30078 Hsinchu City (TW)
(74) Representative: Hoefer & Partner Patentanwälte mbB

(57) **Abstract**

A semiconductor package includes a leadframe (LF) having a die pad (P) and a plurality of pins disposed around the die pad (P), a metal interposer (IP) attached to a top surface of the die pad (P), and a semiconductor die (D) attached to a top surface of the metal interposer (IP). A plurality of bond wires (WS6, WS31) with same function is bonded to the metal interposer (IP). The die pad (P), the metal interposer (IP) and the semiconductor die (D) are stacked in layers so as to form a pyramidal stack structure.

## Description

### Cross Reference to Related Applications

This application claims the benefit of U.S. Provisional Application No. 63/273,169, filed on October 29th, 2021. The content of the application is incorporated herein by reference.

### Background

The present disclosure relates generally to the field of semiconductor packaging. More particularly, the present disclosure relates to a leadframe package with a metal interposer.

The handheld consumer market is aggressive in the miniaturization of electronic products. Driven primarily by the cellular phone and digital assistant markets, manufacturers of these devices are challenged by ever shrinking formats and the demand for more PC-like functionality. Additional functionality can only be achieved with higher performing logic IC's accompanied by increased memory capability. This challenge, combined together in a smaller PC board format, asserts pressure on surface mount component manufactures to design their products to command the smallest area possible.

Many of the components used extensively in today's handheld market are beginning to migrate from traditional leaded frame designs to non-leaded formats. The primary driver for handheld manufacturers is the saved PC board space created by these components' smaller mounting areas. In addition, most components also have reductions in weight and height, as well as an improved electrical performance. As critical chip scale packages are converted to non-leaded designs, the additional space saved can be allocated to new components for added device functionality. Since non-leaded designs can use many existing leadframe processes, costs to convert a production line can be minimized.

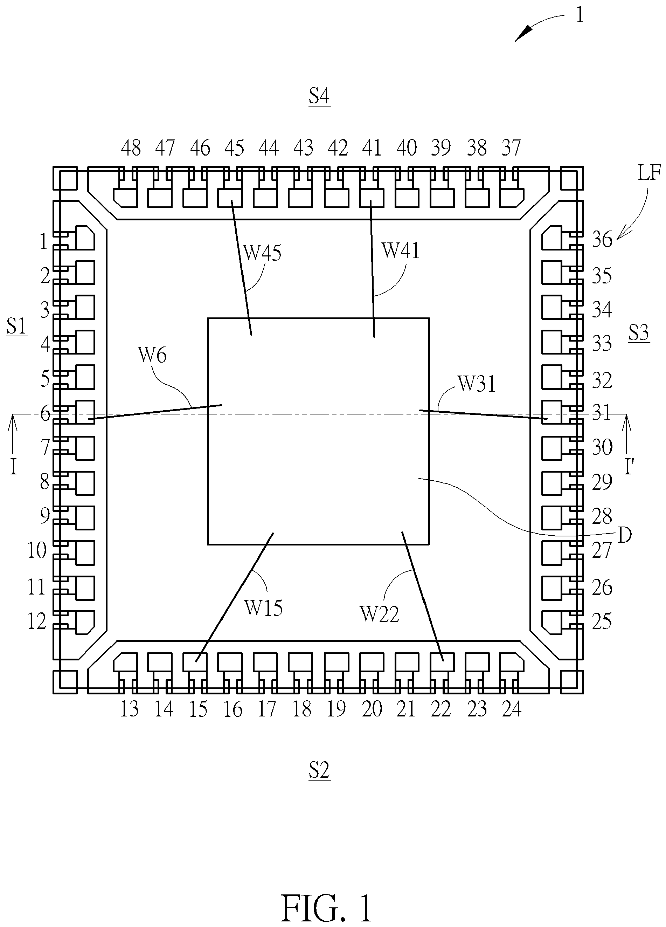

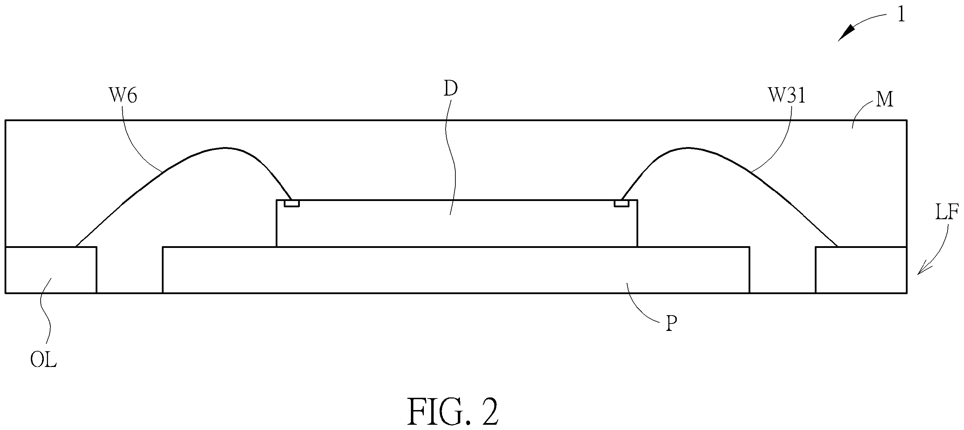

FIG. 1 is a schematic diagram showing a typical layout of a leadframe package. FIG. 2 is a schematic, cross-sectional view taken along line I-I' in FIG. 1. As shown in FIG. 1 and FIG. 2, the leadframe package 1 has a rectangular shape when viewed from the above and has four sides S1-S4. A semiconductor die D is mounted on a die pad P of a leadframe LF and is encapsulated by using a molding compound M. For example, 48 pins may be provided along the four sides S1-S4. On each side, at least one pin is designated to provide the same function or signal such as digital power to avoid issues such as IR drop. By way of example, the pins with same function are denoted as pin No. 6, pin No. 15, pin No. 22, pin No. 31, pin No. 41, and pin No. 45 in FIG. 1. Bond wires W6, W15, W22, W31, W41, and W45 are respectively connected to the pin No. 6, pin No. 15, pin No. 22, pin No. 31, pin No. 41, and pin No. 45. Other bond wires are omitted for the sake of simplicity.

The leadframe package 1 requires multiple bond wires for bonding with multiple pins with same function, which inevitably increase the package cost and customer PCB area. It is desirable to provide a leadframe with reduced pin count along the four sides of the leadframe package without affecting the functionality of the device.

### Summary

One object of the present invention is to provide an improved leadframe package having a metal interposer in order to solve the above-mentioned problems or shortcomings. A semiconductor package according to the invention is defined in independent claim 1. The dependent claims define preferred embodiments thereof.

One aspect of the invention provides a semiconductor package including a leadframe comprising a die pad and a plurality of pins disposed around the die pad, a metal interposer attached to a top surface of the die pad, and a semiconductor die attached to a top surface of the metal interposer. A plurality of bond wires with same function is bonded to the metal interposer.

Preferably, the metal interposer is attached to the top surface of the die pad with a first nonconductive adhesive film, and wherein the semiconductor die is attached to the top surface of the metal interposer with a second nonconductive adhesive film.

Preferably, the first nonconductive adhesive film and the second nonconductive adhesive film comprise epoxy or polyimide.

Preferably, the metal interposer is a monolithic and continuous metal sheet.

Preferably, a connection bond wire is disposed to electrically connect the metal interposed with a signal pin that provides the plurality of bond wires with same functional signal.

Preferably, the same functional signal provided by the signal pin comprises digital power.

Preferably, the metal interposer, the semiconductor die and the plurality of bond wires with same function are encapsulated by a molding compound.

Preferably, the die pad, the metal interposer and the semiconductor die are stacked in layers so as to form a pyramidal stack structure.

Preferably, the metal interposer has a surface area that is smaller than that of the die pad such that a peripheral region of the die pad is spared for ground bond wires.

Preferably, at least one opening penetrates through the metal interposer and the first nonconductive adhesive film, and at least one shorter ground bond wire is bonded to the die pad through the opening.

Preferably, the metal interposer is a multi-piece metal interposer comprising physically separated sub-interposers that provides different function signals.

These and other objectives of the present invention will no doubt become obvious to those of ordinary skill in the art after reading the following detailed description of the preferred embodiment that is illustrated in the various figures and drawings.

### Brief Description of the Drawings

The accompanying drawings are included to provide a further understanding of the invention and are incorporated in and constitute a part of this specification. The drawings illustrate embodiments of the invention and, together with the description, serve to explain the principles of the invention. In the drawings:
FIG. 1 is a schematic diagram showing a typical layout of a leadframe package;
FIG. 2 is a schematic, cross-sectional view taken along line I-I' in FIG. 1;
FIG. 3 is a schematic diagram showing an exemplary layout of a leadframe package with a metal interposer according to an embodiment of the invention;
FIG. 4 is a schematic, cross-sectional view taken along line II-II' in FIG. 3;
FIG. 5 is a schematic, cross-sectional diagram showing another embodiment of the present invention; and
FIG. 6 is a schematic, cross-sectional diagram showing still another embodiment of the present invention.

### Detailed Description

In the following detailed description of embodiments of the invention, reference is made to the accompanying drawings, which form a part hereof, and in which is shown by way of illustration specific preferred embodiments in which the disclosure may be practiced.

These embodiments are described in sufficient detail to enable those skilled in the art to practice them, and it is to be understood that other embodiments may be utilized and that mechanical, chemical, electrical, and procedural changes may be made without departing from the spirit and scope of the present disclosure. The following detailed description is, therefore, not to be taken in a limiting sense, and the scope of embodiments of the present invention is defined only by the appended claims.

It will be understood that when an element or layer is referred to as being "on", "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numbers refer to like elements throughout. As used herein, the term "and/or" includes any and all combinations of one or more of the associated listed items.

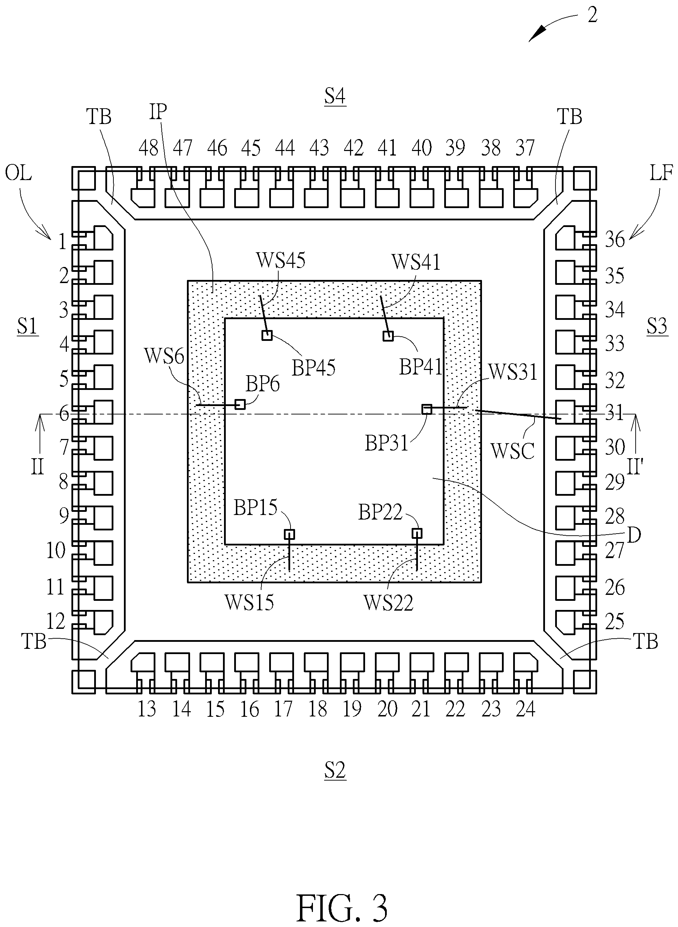

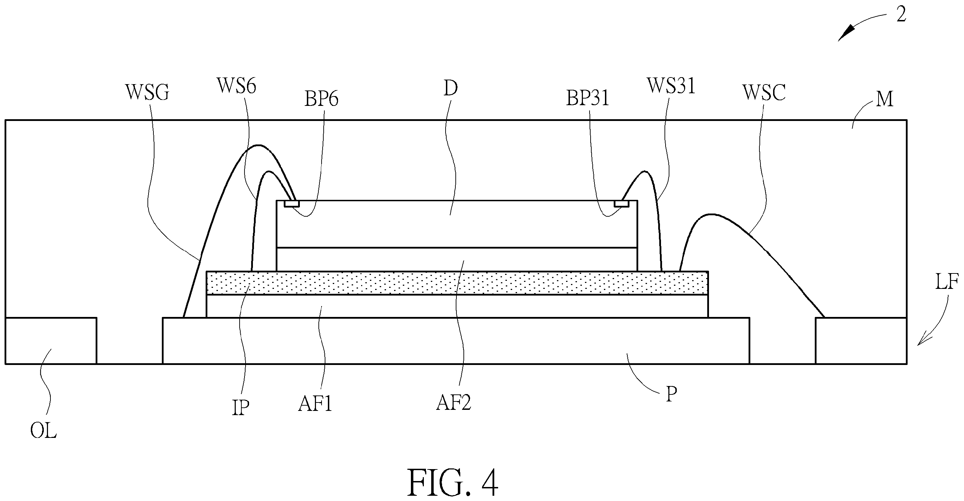

Please refer to FIG. 3 and FIG. 4. FIG. 3 is a schematic diagram showing an exemplary layout of a leadframe package 2 with a metal interposer IP according to an embodiment of the invention. FIG. 4 is a schematic, cross-sectional view taken along line II-II' in FIG. 3. Like regions, layers or elements are designated with like numeral numbers or labels. As shown in FIG. 3 and FIG. 4, the leadframe package 2 may have a rectangular shape when viewed from the above and may have four sides S1-S4. A semiconductor die D may be mounted on a die pad P of a leadframe LF and is encapsulated by using a molding compound M. Preferably, the space between the leads OL and the die pad P may be filled with the molding compound M.

Preferably, a metal interposed IP that may be consisted of a monolithic and continuous metal sheet such as a monolithic copper or aluminum sheet or film is interposed between the die pad P and the semiconductor die D. Preferably, the metal interposed IP may be adhered to the top surface of the die pad P by using a nonconductive adhesive film AF1 such as epoxy, polyimide, or any suitable die attach films. Preferably, the semiconductor die D may be adhered to the top surface of the metal interposed IP by using a nonconductive adhesive film AF2 such as epoxy, polyimide, or any suitable die attach films.

Preferably, for example, the plurality of pins or leads OL such as a total of 48 pins may be provided along the four sides S1-S4. The four rows of pins or leads OL may be separated by four tie bars TB disposed respectively at four corners of the leadframe package 2. Preferably, the 48 pins may be coplanar with the die pad P with their bottom surfaces exposed from the bottom surface of the molding compound M. On the active surface of the semiconductor die D, a plurality of input/output (I/O) pads such as six pads BP6, BP15, BP22, BP31, BP41, and BP45, which are used to bonded to respective pins such as pin No. 6, pin No. 15, pin No. 22, pin No. 31, pin No. 41, and pin No. 45 having the same function such as digital power on four sides S1-S4, are bonded to the metal interposed IP through shorter bond wires WS6, WS15, WS22, WS31, WS41, and WS45.

A connection bond wire WSC is provided to electrically connect the metal interposer IP with the exemplary pin No. 31 that provides the six pads BP6, BP15, BP22, BP31, BP41, and BP45 with same functional signal such as digital power. The die pad P, the metal interposer IP and the semiconductor die D are stacked in layers so as to form a pyramidal stack structure. It is noteworthy that the metal interposer IP has a surface area that is smaller than that of the die pad P such that a peripheral region of the die pad P can be spared and used to bond the ground bond wires WSG.

Preferably, the exemplary five pins including pin No. 6, pin No. 15, pin No. 22, pin No. 41, and pin No. 45 may be spared or canceled to reduce total pin count and the dimension of the leadframe package. Alternatively preferably, the spared five pins including pin No. 6, pin No. 15, pin No. 22, pin No. 41, and pin No. 45 may be designated for extra function signals.

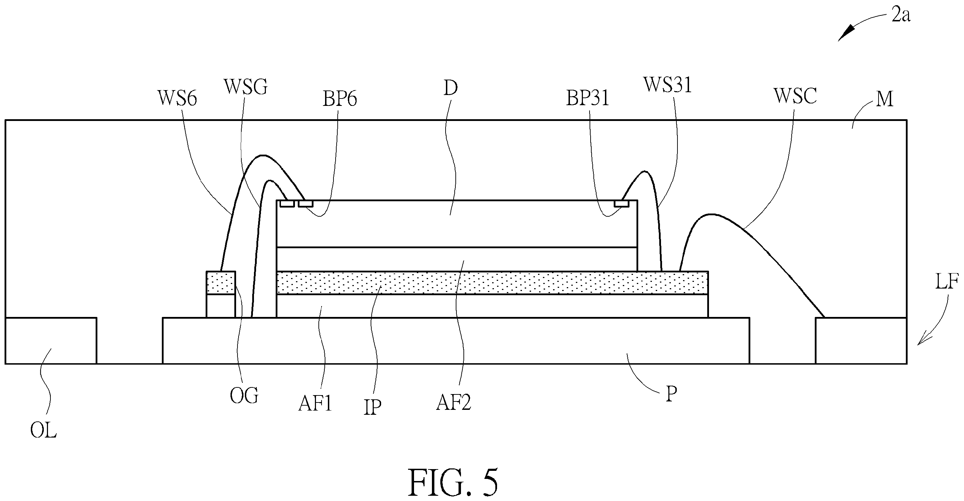

FIG. 5 is a schematic, cross-sectional diagram showing another embodiment of the present invention. As shown in FIG. 5, the differences between the structure of the leadframe package 2a in FIG. 5 and the structure of the leadframe package 2 in FIG. 4 includes that the leadframe package 2a in FIG. 5 comprises at least one opening OG that penetrates through the metal interposer IP and the nonconductive adhesive film AF1. At least one shorter ground bond wire WSG is bonded to the die pad P through the opening OG. By providing such configuration, a shorter ground signal path can be obtained and the performance of the leadframe package is improved. It is understood that the opening OG may be an elongated trench or slit disposed along at least one side of the metal interposer IP or may comprise individual holes.

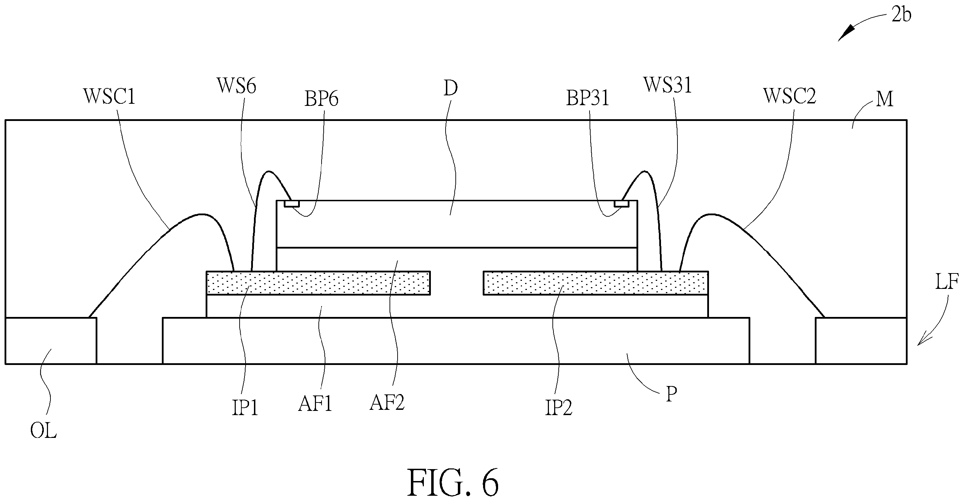

FIG. 6 is a schematic, cross-sectional diagram showing still another embodiment of the present invention. As shown in FIG. 6, the differences between the structure of the leadframe package 2b in FIG. 6 and the structure of the leadframe package 2 in FIG. 4 includes that the leadframe package 2b in FIG. 6 comprises a multi-piece metal interposer such as two-piece metal interposer. Preferably, for example, the metal interposer IP in FIG. 4 may be split into at least two physically separated sub-interposers IP1 and IP2, which provides different function signals such as different digital power signals. A connection bond wire WSC1 and a connection bond wire WSC2 are provided to electrically connect the sub-interposers IP1 and IP2 to the respective pins or leads OL. For example, the bond wire WS6 may be electrically connected to the sub-interposer IP1 and the bond wire WS31 may be electrically connected to the other sub-interposer IP2.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. A semiconductor package, comprising:
a leadframe (LF) comprising a die pad (P) and a plurality of pins (1 - 48) disposed around the die pad (P);
a metal interposer (IP) attached to a top surface of the die pad (P); and
a semiconductor die (D) attached to a top surface of the metal interposer (IP), wherein a plurality of bond wires (WS6, WS15, WS22, WS31, WS41, WS45) with same function is bonded to the metal interposer (IP).

2. The semiconductor package according to claim 1, wherein the metal interposer (IP) is attached to the top surface of the die pad (P) with a first nonconductive adhesive film (AF1), and wherein the semiconductor die (D) is attached to the top surface of the metal interposer (IP) with a second nonconductive adhesive film (AF2).

3. The semiconductor package according to claim 2, wherein the first nonconductive adhesive film (AF1) and the second nonconductive adhesive film (AF2) comprise epoxy or polyimide.

4. The semiconductor package according to any one of claims 1 to 3, wherein the metal interposer (IP) is a monolithic and continuous metal sheet.

5. The semiconductor package according to any one of claims 1 to 4, wherein a connection bond wire (WSC) is disposed to electrically connect the metal interposer (IP) with a signal pin (31) that provides the plurality of bond wires (WS6, WS15, WS22, WS31, WS41, WS45) with same functional signal.

6. The semiconductor package according to claim 5, wherein the same functional signal provided by the signal pin (31) comprises digital power.

7. The semiconductor package according to any one of claims 1 to 6, wherein the metal interposer (IP), the semiconductor die (D) and the plurality of bond wires (WS6, WS15, WS22, WS31, WS41, WS45) with same function are encapsulated by a molding compound (M).

8. The semiconductor package according to any one of claims 1 to 7, wherein the die pad (P), the metal interposer (IP) and the semiconductor die (D) are stacked in layers so as to form a pyramidal stack structure.

9. The semiconductor package according to any one of claims 1 to 8, wherein the metal interposer (IP) has a surface area that is smaller than that of the die pad (P) such that a peripheral region of the die pad (P) is spared for ground bond wires (WSG).

10. The semiconductor package according to claim 2 or 3 or any one of claims 4 to 9 in combination with claim 2 or 3, wherein at least one opening (OG) penetrates through the metal interposer (IP) and the first nonconductive adhesive film (AF1), and at least one shorter ground bond wire (WSG) is bonded to the die pad (P) through the opening (OG).

11. The semiconductor package according to any one of claims 1 to 10, wherein the metal interposer (IP) is a multi-piece metal interposer comprising physically separated sub-interposers (IP1, IP2) that provide different function signals.
